# EUROPÄISCHE PATENTSCHRIFT

(11) **EP 3 433 897 B1**
(45) Veröffentlichungstag und Bekanntmachung des Hinweises auf die Patenterteilung: **14.10.2020**
(21) Anmeldenummer: 17707212.1
(22) Anmeldetag: 20.02.2017
(51) Int. Cl.: H01M 10/48, H01R 12/58, H01M 10/42, H01R 11/28

(54) **DECKEL FÜR EIN GEHÄUSE, BATTERIESENSOR UND VERFAHREN ZUM HERSTELLEN EINES BATTERIESENSORS**
COVER FOR A HOUSING, BATTERY SENSOR AND METHOD FOR PRODUCING A BATTERY SENSOR
COUVERCLE DE BOÎTIER, CAPTEUR DE BATTERIE ET PROCÉDÉ DE FABRICATION D'UN CAPTEUR DE BATTERIE

(30) Priorität: 24.03.2016 DE 102016204942
(43) Veröffentlichungstag der Anmeldung: 30.01.2019
(73) Patentinhaber: Continental Automotive GmbH, 30165 Hannover (DE)
(72) Erfinder: SCHRAMME, Martin, 86343 Königsbrunn (DE)
(86) Internationale Anmeldenummer: PCT/EP2017/053776
(87) Internationale Veröffentlichungsnummer: WO 2017/162382

(56) Entgegenhaltungen:
- WO-A1-2014/203465
- DE-A1-102012 223 940
- DE-U1-202004 012 466
- DE-U1-202004 012 466
- JP-A- 2005 011 587
- US-B1- 6 305 949

## Beschreibung

Die Erfindung betrifft einen Deckel für ein Gehäuse, einen Batteriesensor mit einem solchen Deckel und ein Verfahren zum Herstellen eines Batteriesensors.

Batteriesensoren werden in zahlreichen elektrischen Geräten und insbesondere auch in Automobilen beispielsweise verwendet, um Ströme zu messen, mit welchen eine Batterie wie beispielsweise eine Autobatterie geladen oder entladen wird. Beispielsweise kann dabei ein Messwiderstand, auch als Shunt bezeichnet, verwendet werden, durch welchen der jeweilige Strom durchfließt und über welchem eine abfallende Spannung gemessen wird. Über das Ohm'sche Gesetz kann dann auf den durchfließenden Strom geschlossen werden.

Ein solcher Messwiderstand kann beispielsweise in Form eines massiven metallischen elektrischen Leiters ausgebildet sein. Dabei stellt sich häufig das Problem, dass dieser mit einer Leiterplatte zu verbinden ist, wobei Messwiderstand und Leiterplatte in einem gemeinsamen Gehäuse angeordnet werden sollen und die Leiterplatte außerdem mit einem in das Gehäuse integrierten Stecker kontaktiert werden soll.

Hierzu können beispielsweise bekannte Pressfit-Verbindungen verwendet werden. Ein wichtiges Merkmal von Pressfit-Verbindungen ist die sogenannte Pressfitzone, die zum Beispiel augenförmig gestaltet sein kann. Es handelt sich um eine in den Pin eingestanzte Struktur, die zum einen in wenigstens einer Richtung dicker ist als der Pin selbst und zum anderen eine elastische Verformung zulässt, über welche die Haltekräfte der Pressfit-Verbindung erreicht werden.

Solche Pressfitpins sind beispielsweise in der DE 10 2012 223 940 A1, JP 2005 011 587 A oder der US 6,305,949 B1 gezeigt.

Seit einigen Jahren kommen Pressfit-Verbindungen auch in Batteriesensoren zum Einsatz, und zwar in zwei grundsätzlich verschiedenen Anwendungsarten. Zum einen werden elektrische Verbindungen vom Messwiderstand zur Leiterplatte benötigt, um die am Messwiderstand abfallende Spannung auf die Leiterplatte zu führen und mittels der darauf befindlichen Bauteile zu messen und auszuwerten. Zum anderen werden elektrische Verbindungen von der Leiterplatte zu einem Stecker benötigt, über welche die Leiterplatte mit der Batteriespannung versorgt wird und eine Kommunikationsschnittstelle angeschlossen wird. Ein solcher Batteriesensor ist beispielsweise in der WO 2014 203 465 A1 gezeigt.

Der Stecker ist in der Regel in ein Gehäuse integriert, in dem sich auch die Leiterplatte und der Messwiderstand befinden. Kontaktstifte des Steckers werden typischerweise aus einem Stanzgitter herausgestanzt und an einem Ende mit Pressfit-Kontakten versehen. In weiteren Arbeitsschritten kann dann der Messwiderstand ebenfalls mit zuvor durch Stanzen hergestellten Pressfit-Kontakten versehen werden, welche beispielsweise auf den Messwiderstand geschweißt werden. Anschließend können das Stanzgitter und der Messwiderstand mit dem Gehäusematerial so umspritzt werden, dass die Pressfitzonen aller Pins ins Innere des Gehäuses ragen und dort auf einer Ebene mit der vorgesehenen Position der Leiterplatte liegen. In späteren Arbeitsschritten kann die Leiterplatte in das Gehäuse mit den Pressfitpins eingepresst und mit einem Deckel verschlossen werden.

Es hat sich gezeigt, dass die Ausführungen gemäß dem Stand der Technik insbesondere den Nachteil aufweisen, dass die Herstellung der Pins für den Messwiderstand, die Herstellung der Pins für den Stecker, das Verbinden der Pins des Messwiderstands mit dem Messwiderstand und das Umspritzen von Messwiderstand und Stanzgitter mit dem Gehäuse jeweils in eigenen Arbeitsgängen stattfinden, was insgesamt zu einer besonders aufwändigen Verfahrensführung führt.

Es ist deshalb eine Aufgabe der Erfindung, einen Deckel vorzusehen, bei welchem eine einfachere Ausführung und/oder Verfahrensführung möglich ist. Es ist des Weiteren eine Aufgabe der Erfindung, einen Batteriesensor mit einem solchen Deckel vorzusehen. Außerdem ist es eine Aufgabe der Erfindung, ein zugehöriges Verfahren zur Herstellung eines Batteriesensors vorzusehen.

Dies wird erfindungsgemäß durch einen Deckel nach Anspruch 1, einen Batteriesensor nach Anspruch 10 und ein Verfahren nach Anspruch 13 erreicht. Vorteilhafte Ausgestaltungen können beispielsweise den jeweiligen Unteransprüchen entnommen werden.

Die Erfindung betrifft einen Deckel für ein Gehäuse. Der Deckel weist eine Trägerstruktur und eine Anzahl von Pressfitpins auf, welche von der Trägerstruktur abstehen. Die Trägerstruktur ist von einem Deckelmaterial ummantelt. Jeder Pressfitpin einer ersten Gruppe von Pressfitpins weist jeweils eine erste Pressfitzone und eine zweite Pressfitzone auf, wobei die erste Pressfitzone näher an der Trägerstruktur angeordnet ist als die zweite Pressfitzone. Die erste Pressfitzone weist eine größere maximale Querschnittsfläche auf als die zweite Pressfitzone. Der Deckel ist mit einem ersten Fügepartner und einem zweiten Fügepartner verbunden, wobei die ersten Pressfitzonen in den ersten Fügepartner eingepresst und die zweiten Pressfitzonen sind in den zweiten Fügepartner eingepresst sind. Der erste Fügepartner ist ein Messwiderstand und der zweite Fügepartner ist eine Leiterplatte.

Mittels des erfindungsgemäßen Deckels ist es in besonders einfacher Weise möglich, zwei benachbarte elektrische Komponenten, nämlich eine Leiterplatte und einen Messwiderstand, gleichzeitig mittels der Pressfitpins zu kontaktieren. Hierzu wird eine erste Komponente mittels der ersten Pressfitzone kontaktiert und eine zweite Komponente mittels der zweiten Pressfitzone kontaktiert. Dies kann in einem sehr einfachen Fertigungsprozess erfolgen. Hierauf wird weiter unten näher eingegangen werden.

Eine Pressfitzone ist dabei typischerweise eine Zone, welche dazu ausgebildet ist, mit einer anderen Komponente, beispielsweise einer Leiterplatte oder einem Messwiderstand, verbunden zu werden. Hierzu ist eine jeweilige Pressfitzone typischerweise mit einem in Längsrichtung des Pressfitpins gesehen zunächst ansteigenden und dann wieder abfallenden Querschnitt ausgebildet. Der maximale Querschnitt bezieht sich somit typischerweise auf eine jeweilige Ebene quer zur Längsrichtung des Pressfitpins. Die Pressfitzonen sind dabei bevorzugt elastisch, so dass ein besonders vorteilhafter Kontakt hergestellt werden kann.

Der vorstehend beschriebene Deckel erlaubt eine vorteilhafte Anordnung, in welcher die beiden Fügepartner über die Pressfitpins der ersten Gruppe miteinander und gegebenenfalls mit anderen Komponenten verbunden sind, und in welcher der zweite Fügepartner mit externen Komponenten separat verbunden werden kann. Insbesondere, wenn der erste Fügepartner ein Messwiderstand und der zweite Fügepartner eine Leiterplatte ist, hat sich dies gerade für Anwendungen in einem Batteriesensor als vorteilhaft erwiesen.

Die Pressfitpins der ersten Gruppe sind bevorzugt materialschlüssig mit der Trägerstruktur ausgebildet. Dies erlaubt eine einfache Herstellung und eine zuverlässige elektrische Verbindung. Insbesondere können die Trägerstruktur und die Pressfitpins der ersten Gruppe aus einem gemeinsamen Blech gestanzt bzw. geformt werden. Es kann insbesondere bei der Verwendung von Ausstanzverfahren auch von einer Stanzgitterstruktur gesprochen werden, welche sowohl die Trägerstruktur wie auch die damit verbundenen Pressfitpins umfasst.

Gemäß einer Weiterbildung weist jeder Pressfitpin einer zweiten Gruppe von Pressfitpins eine Querschnittsfläche auf, welche durchgehend kleiner ist als die maximale Querschnittsfläche der ersten Pressfitzone. Dies ermöglicht es, die Pressfitpins der zweiten Gruppe von Pressfitpins dazu zu benutzen, lediglich eine von zwei Komponenten zu kontaktieren, welche von den Pressfitpins der ersten Gruppe kontaktiert wird. Hierzu kann insbesondere ein jeweiliger Pressfitpin der zweiten Gruppe durch entsprechend große Löcher der nicht zu kontaktierenden Komponente hindurchtreten und mit einer zu kontaktierenden Komponente verbunden sein.

Gemäß einer Ausführung umfasst die zweite Gruppe zumindest ein Paar von nebeneinander angeordneten Pressfitpins. Dies hat sich für typische Anwendungen als zweckmäßig erwiesen. Insbesondere kann eine Verbindungslinie zwischen den Pressfitpins eines Paars quer zu einer Stromrichtung eines Batteriesensors sein. Dies vermeidet die Einführung von Asymmetrien, welche den Stromfluss in schwer vorhersehbarer Weise beeinflussen könnten. Anstelle eines Paars von Pressfitpins kann auch eine Anordnung von mehr als zwei, beispielsweise drei, vier oder mehr Pressfitpins verwendet werden. Auch diese können eine Verbindungslinie haben, welche quer zu einer Stromrichtung eines Batteriesensors ist.

Die Pressfitpins der zweiten Gruppe können auch mit der Trägerstruktur materialschlüssig verbunden sein.

Die erste Pressfitzone und die zweite Pressfitzone können jeweils voneinander beabstandet sein. Die erste Pressfitzone kann jedoch auch jeweils an die zweite Pressfitzone unmittelbar angrenzen. Es sei verstanden, dass diese Ausführungen auch bei mehreren Pressfitpins miteinander kombinierbar sind.

Gemäß einer Ausführung umfasst die erste Gruppe vier Pressfitpins, welche in einem ersten Paar und einem zweiten Paar hintereinander angeordnet sind. Dies hat sich für typische Anwendungen als vorteilhaft erwiesen. Insbesondere können Verbindungslinien zwischen den jeweiligen Pressfitpins jedes Paars quer zu einer Stromrichtung ausgerichtet sein, was eine potentialgleiche Messung ermöglicht. Durch die Verwendung eines Paars von Pressfitpins kann die jeweilige Stromtragfähigkeit erhöht, insbesondere verdoppelt werden, ohne auf eine andere Stärke eines Blechs ausweichen zu müssen. Die Pressfitpins eines jeweiligen Paars können insbesondere zusammengeschaltet sein, beispielsweise durch entsprechende Ausgestaltung der Trägerstruktur, was vorteilhaft ist, wenn sie potentialgleich messen.

Anstelle eines Paars können auch jeweils mehr als zwei, beispielsweise drei, vier oder mehr Pressfitpins verwendet werden. Auch diese können eine Verbindungslinie haben, welche quer zu einer Stromrichtung eines Batteriesensors ist und sie können zusammengeschaltet sein.

Gemäß einer Weiterbildung weist der Deckel ferner einen integrierten Stecker auf. Dies kann insbesondere dazu dienen, einen elektrischen Anschluss zwischen innerhalb eines Gehäuses befindlichen Komponenten und dazu externen Komponenten herzustellen.

Insbesondere können die Pressfitpins der zweiten Gruppe mit elektrischen Leitern des Steckers verbunden sein. Dies ermöglicht ein spezifisches Kontaktieren einer der Komponenten mittels des Steckers.

Bevorzugt verbindet die Trägerstruktur eine Anzahl von Pressfitpins mit anderen Pins und/oder anderen elektrischen Leitern. Dies ermöglicht eine flexible und einfache Herstellung auch komplexerer elektrischer Verbindungen zwischen Pressfitpins und anderen elektrischen Leitern. Sofern Pressfitpins der zweiten Gruppe vorhanden sind, sind diese vorzugsweise in den zweiten Fügepartner eingepresst, können aber beispielsweise alternativ oder zusätzlich dazu auch in den ersten Fügepartner einpresst sein.

Die Erfindung betrifft des Weiteren ein Gehäuse mit einem solchen Deckel, welches einen Innenraum umschließt. Ein solches Gehäuse kann insbesondere für einen mechanischen Schutz sorgen und kann des Weiteren abgedichtet sein gegen das Eindringen von Flüssigkeit und/oder schädlichen Substanzen.

Die Erfindung betrifft des Weiteren einen Batteriesensor, welcher einen Messwiderstand und eine Messschaltung aufweist, welche dazu konfiguriert ist, eine über zumindest einem Teil des Messwiderstands abfallende Spannung zu messen. Erfindungsgemäß ist bei dem Batteriesensor vorgesehen, dass der Messwiderstand als Teil eines die Messschaltung umschließenden Gehäuses ausgebildet ist. Der Batteriesensor weist dabei einen unteren und/oder einen oberen Deckel auf, wobei der Messwiderstand und der oder die Deckel zusammen das Gehäuse bilden. Erfindungsgemäß ist zumindest einer der Deckel gemäß der Erfindung ausgebildet. Dabei kann auf alle beschriebenen Ausführungen und Varianten eines Deckels zurückgegriffen werden. Die ersten Pressfitzonen sind dabei in den Messwiderstand eingepresst und die Messschaltung ist bevorzugt auf einer Leiterplatte aufgebracht, in welche die zweiten Pressfitzonen eingepresst sind.

Mittels des erfindungsgemäßen Batteriesensors können die weiter oben beschriebenen Vorteile eines erfindungsgemäßen Deckels für einen Batteriesensor nutzbar gemacht werden. Insbesondere kann die Messschaltung eine über dem Messwiderstand abfallende Spannung messen, so dass auf einen durchfließenden Strom geschlossen werden kann. Es kann sich hierbei insbesondere um einen langzeit- und/oder temperaturstabilen Messwiderstand handeln, oder es kann sich um einen weniger stabilen Messwiderstand handeln, welcher laufend kalibriert wird.

Gemäß einer bevorzugten Ausführung sind die Pressfitpins der zweiten Gruppe mit elektrischen Leitern eines Steckers verbunden. Pressfitzonen der Pressfitpins der zweiten Gruppe sind in die Leiterplatte eingepresst. Dies ermöglicht es besonders vorteilhaft, die Leiterplatte separat vom Messwiderstand mit außerhalb des Batteriesensors liegenden Komponenten zu verbinden. Beispielsweise kann über die Pressfitpins der zweiten Gruppe die Leiterplatte mit einer Fahrzeugelektronik verbunden werden. Hierbei besteht keine elektrische Verbindung zum Messwiderstand, welche in diesem Fall auch nicht erwünscht ist. Eine paarweise Anordnung der Pressfitpins der zweiten Gruppe mit einer Verbindungslinie quer zu einer Stromrichtung des Batteriesensors kann insbesondere Asymmetrien vermeiden, welche Messungen in schwer zu bestimmender Weise beeinflussen könnten. Gemäß einer bevorzugten Ausführung umfasst die erste Gruppe vier Pressfitpins, welche in einem ersten Paar und einem zweiten Paar hintereinander angeordnet sind. Dabei ist besonders bevorzugt vorgesehen, dass das erste Paar in der Stromrichtung des Batteriesensors gesehen vor dem zweiten Paar angeordnet ist, eine Verbindungslinie zwischen den Pressfitpins des ersten Paars quer zur Stromrichtung ausgerichtet ist und eine Verbindungslinie zwischen den Pressfitpins des zweiten Paars quer zur Stromrichtung ausgerichtet ist. Damit können die Pressfitpins eines jeweiligen Paars insbesondere potentialgleich messen. Durch die Verwendung von Paaren von Pressfitpins wird die Stromtragfähigkeit erhöht, ohne auf dickeres Material zurückgreifen zu müssen.

Die Erfindung betrifft des Weiteren ein Verfahren zum Herstellen eines Batteriesensors, insbesondere eines Batteriesensors gemäß der Erfindung, wobei auf alle beschriebenen Varianten und Ausführungen zurückgegriffen werden kann. Das Verfahren weist folgende Schritte auf:
- Bereitstellung eines erfindungsgemäßen Deckels, wobei auf alle beschriebenen Varianten und Ausführungen zurückgegriffen werden kann,
- Einpressen der ersten Pressfitzonen in einen Messwiderstand, und
- Einpressen der zweiten Pressfitzonen in eine Leiterplatte.

Dieses Verfahren ermöglicht eine besonders vorteilhafte Herstellung eines Batteriesensors, insbesondere eines erfindungsgemäßen Batteriesensors. Durch die besondere Ausgestaltung des Deckels mit den entsprechend ausgeführten Pressfitpins kann durch einfaches Aufstecken eine Kontaktierung von sowohl dem Messwiderstand wie auch der Leiterplatte erreicht werden. Dabei werden auch gute elektrische Kontakte ausgebildet, welche für eine zuverlässige Funktion über eine typische Nutzungsdauer besonders vorteilhaft sind.

Die einzelnen Merkmale der Erfindung ermöglichen insbesondere in einem Arbeitsgang die Herstellung eines Gehäuses mit integrierten Einpresspins für zwei oder mehr Fügepartner, welche miteinander elektrisch verbunden werden sollen. In diesem Zusammenhang sei erwähnt, dass die Pressfitpins grundsätzlich auch mehr als zwei Pressfitzonen aufweisen können, welche entsprechend fortgesetzt werden können, wobei typischerweise eine jeweils weiter entfernt vom Deckel bzw. von einer Trägerstruktur angeordnete Pressfitzone einen kleineren maximalen Querschnitt hat als die jeweils näher am Deckel bzw. der Trägerstruktur liegenden Pressfitzonen.

Das Stanzgitter kann besonders vorteilhaft für alle vorgesehenen elektrischen Verbindungen zugleich gestaltet werden und in das Gehäuse eingespritzt werden. Anschließend kann das Gehäuse mit einem Deckel verschlossen werden. Es entfallen dabei folgende, gemäß dem Stand der Technik typischerweise notwendige Arbeitsgänge: separate Herstellung eines oder mehrerer Pins zur Verbindung des Messwiderstands mit der Leiterplatte und eines Stanzgitters für Steckkontakte; Montage der Pins auf dem Messwiderstand; Fixierung des Messwiderstands mit den Kontakten zum Stanzgitter.

Stattdessen wird ein Stanzgitter mit allen benötigten Pins vorteilhaft auf einmal hergestellt und das Gehäuse darum angespritzt. In zwei weiteren Arbeitsgängen kann insbesondere zuerst der Messwiderstand und dann die Leiterplatte in das Gehäuse eingepresst werden. Schließlich kann das Gehäuse mit einem Deckel verschlossen werden.

Weitere Merkmale und Vorteile wird der Fachmann den nachfolgend mit Bezug auf die beigefügte Zeichnung beschriebenen Ausführungsbeispielen entnehmen. Dabei zeigen:
Fig. 1: eine Querschnittsansicht durch einen erfindungsgemäßen Deckel,
Fig. 2: eine Draufsicht auf den Deckel von Fig. 1,
Fig. 3: die Ansicht von Fig. 2 mit einem eingezeichneten Bereich,
Fig. 4: den eingezeichneten Bereich von Fig. 3 in vergrößerter Darstellung,
Fig. 5: eine Teilansicht des Deckels, und
Fig. 6: einen Batteriesensor.

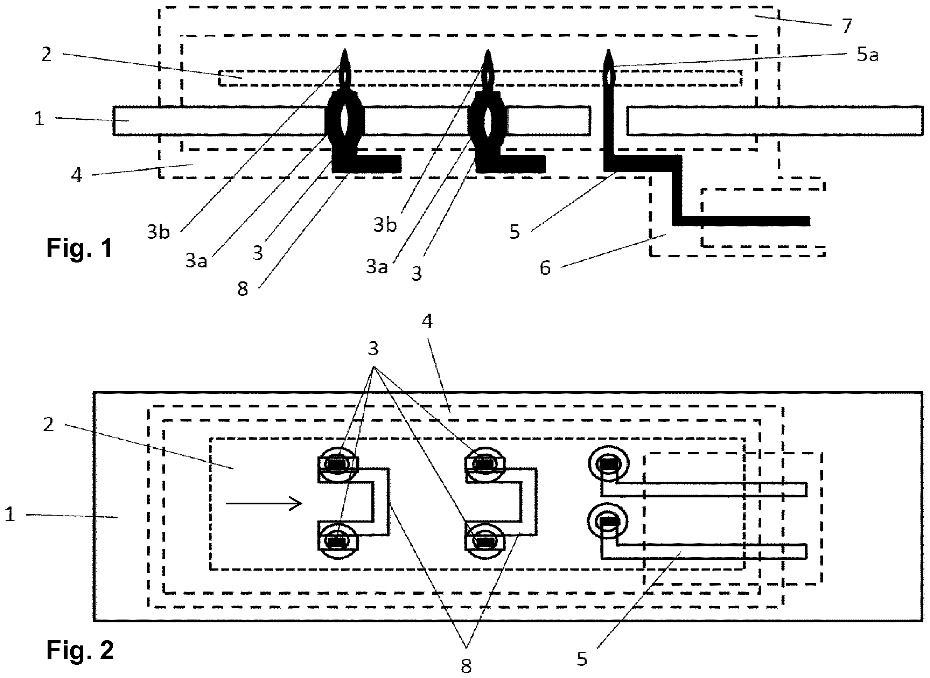

Fig. 1 zeigt, wie ein erster Fügepartner in Form eines Messwiderstands 1 und ein zweiter Fügepartner in Form einer Leiterplatte 2 mittels eines erfindungsgemäßen Deckels 4 miteinander verbunden werden. In dem erfindungsgemäßen Deckel 4 ist eine Anzahl von Pressfitpins 3 einer ersten Gruppe von Pressfitpins angeordnet. Jeder Pressfitpin 3 der ersten Gruppe weist eine jeweilige erste Pressfitzone 3a und eine jeweilige zweite Pressfitzone 3b auf. Die jeweilige zweite Pressfitzone 3b ist dabei weiter von einer Bodenplatte des Deckels 4 beabstandet als die jeweilige erste Pressfitzone 3a.

Des Weiteren weist die jeweilige erste Pressfitzone 3a einen höheren maximalen Querschnitt als die jeweilige zweite Pressfitzone 3b auf. Der Querschnitt ist dabei quer zu einer Längserstreckung des jeweiligen Pressfitpins 3 gesehen.

Die Pressfitpins 3 der ersten Gruppe sind mit einer Trägerstruktur 8 elektrisch verbunden und auch mit weiteren Komponenten verbunden, was nicht näher dargestellt ist. Die Trägerstruktur 8 ist in dem Deckel 4 durch Umspritzen aufgenommen. Dies ermöglicht eine flexible Kontaktierung und einen elektrischen und mechanischen Schutz.

Der Deckel 4 weist des Weiteren eine Anzahl von Pressfitpins 5 einer zweiten Gruppe von Pressfitpins auf. Die jeweiligen Pressfitpins 5 der zweiten Gruppe weisen jeweils nur eine Pressfitzone 5a auf, welche von ihrer Ausgestaltung, d.h. insbesondere in Bezug auf Abstand und maximalen Querschnitt, der jeweiligen zweiten Pressfitzone 3b der Pressfitpins 3 der ersten Gruppe von Pressfitpins entspricht.

Der Deckel 4 weist des Weiteren einen Stecker 6 auf, wobei Leiter des Steckers 6 mit den Pressfitpins 5 der zweiten Gruppe von Pressfitpins verbunden sind.

Zusammen mit weiteren, nicht näher beschriebenen Komponenten bildet der Deckel 4 ein Gehäuse 7 aus. Dieses umschließt einen Innenraum, in welchem sich insbesondere die Leiterplatte 2 befindet und über welchen vorliegend der Messwiderstand 1 heraussteht.

Wie gezeigt ist der Messwiderstand 1 mit den jeweiligen ersten Pressfitzonen 3a der Pressfitpins 3 der ersten Gruppe von Pressfitpins verbunden, indem diese ersten Pressfitzonen 3a in den Messwiderstand 1 eingepresst sind. Wie gezeigt wird der Messwiderstand 1 dadurch vorliegend an zwei Stellen entlang seiner Längserstreckung kontaktiert, was insbesondere das Messen einer über einem Teil des Messwiderstands 1 abfallenden Spannung ermöglicht.

Die Leiterplatte 2 ist sowohl mit den zweiten Pressfitzonen 3b der Pressfitpins 3 der ersten Gruppen von Pressfitpins wie auch mit den Pressfitzonen 5a der Pressfitpins 5 der zweiten Gruppe von Pressfitpins verbunden. Ersteres ermöglicht es einer auf der Leiterplatte 2 befindlichen Elektronik, die über dem entsprechenden Teil des Messwiderstands 1 abfallende Spannung zu messen. Zweiteres ermöglicht eine Kontaktierung der Leiterplatte 2 von außen.

Dabei ist insbesondere anzumerken und auch gut in Fig. 1 zu erkennen, dass die Pressfitpins 5 der zweiten Gruppe von Pressfitpins nicht mit dem Messwiderstand 1 kontaktiert sind, sondern durch entsprechende Löcher im Messwiderstand 1 hindurchdringen. Dies wird durch den gezeigten vorteilhaften Aufbau in einfacher Weise ermöglicht.

Fig. 2 zeigt eine Draufsicht auf den Deckel 4 von Fig. 1. Dabei ist zu erkennen, dass insgesamt vier Pressfitpins 3 der ersten Gruppe von Pressfitpins vorhanden sind, welche in zwei Paaren angeordnet sind. Außerdem ist zu erkennen, dass zwei Pressfitpins 5 der zweiten Gruppe von Pressfitpins vorhanden sind, welche in einem Paar angeordnet sind. Bezüglich der Details sei auf die Beschreibung von Fig. 1 verwiesen.

Eine typische Stromflussrichtung ist in Fig. 2 durch einen Pfeil eingezeichnet.

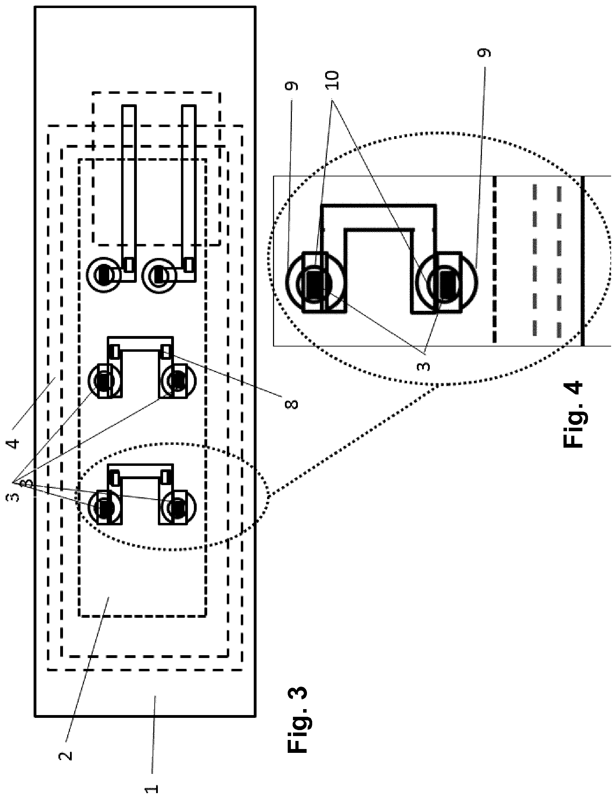

Fig. 3 zeigt die gleiche Darstellung wie Fig. 2, jedoch ist in Fig. 3 zusätzlich ein Bereich eingezeichnet, welcher in Fig. 4 vergrößert dargestellt ist.

Fig. 4 zeigt die Anordnung zweier Pressfitpins 3 der ersten Gruppe von Pressfitpins in einer vergrößerten Darstellung. Dabei ist insbesondere zu erkennen, dass die Pressfitpins 3 sowohl mit ersten Pressfit-Löchern 9, welche im Messwiderstand 1 ausgebildet sind, wie auch mit zweiten Pressfit-Löchern 10, welche in der Leiterplatte 2 ausgebildet sind, in Kontakt stehen. Dies ermöglicht die bereits beschriebene vorteilhafte elektrische Verbindung zum Messen einer Spannung.

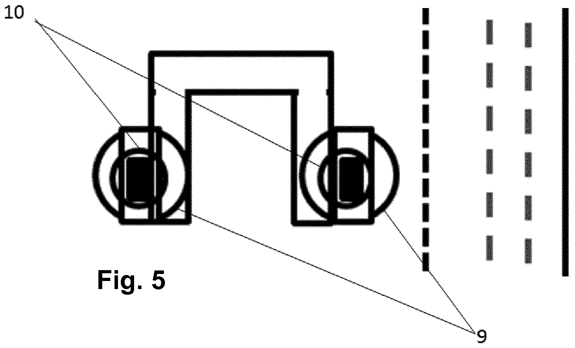

Fig. 5 zeigt die Darstellung von Fig. 4 in nochmals vergrößerter Ansicht. Bezüglich der Details sei auf die obige Beschreibung verwiesen. Insbesondere ist dabei zu erkennen, dass die ersten Pressfit-Löcher 9 wesentlich größer sind als die zweiten Pressfit-Löcher 10, was auch den entsprechenden maximalen Querschnitten der ersten und zweiten Pressfitzonen 3a, 3b entspricht. Dies ermöglicht die bereits beschriebene Art der Kontaktierung.

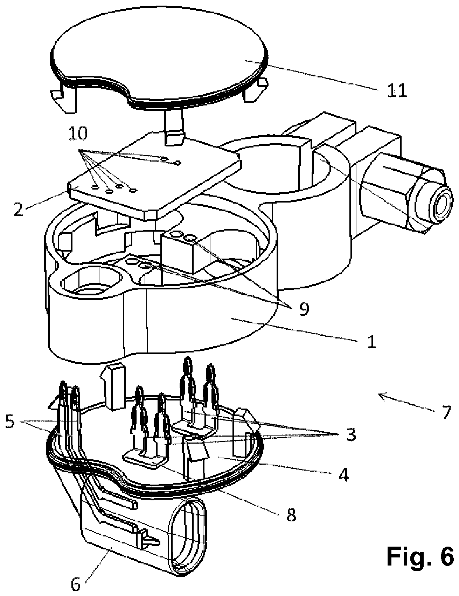

Fig. 6 zeigt ein Ausführungsbeispiel eines erfindungsgemäßen Batteriesensors. Dabei ist der Deckel 4 zu erkennen, von welchem die insgesamt vier Pressfitpins 3 der ersten Gruppe von Pressfitpins und die zwei Pressfitpins 5 der zweiten Gruppe von Pressfitpins abstehen.

Über dem Deckel 4 ist ein Messwiderstand 1 ausgebildet, in welchem die vier ersten Pressfit-Löcher 9 zur Aufnahme der ersten Pressfitzonen 3a der Pressfitpins 3 der ersten Gruppe ausgebildet sind. Unmittelbar darüber ist die Leiterplatte 2 angeordnet, in welcher insgesamt sechs zweite Pressfit-Löcher 10 angeordnet sind. Diese dienen zur Aufnahme der zweiten Pressfitzonen 3b der Pressfitpins 3 der ersten Gruppe sowie der Pressfitzonen 5a der Pressfitpins 5 der zweiten Gruppe. Damit kann die oben bereits erwähnte elektrische Kontaktierung hergestellt werden.

Erwähnenswert an der gezeigten Ausführung ist die Tatsache, dass der Messwiderstand 1 einen Teil des Gehäuses 7 darstellt. Dies erlaubt eine vorteilhafte kompakte und dichte Ausführung. Das Gehäuse 7 weist zur Komplettierung ferner noch einen weiteren Deckel 11 auf, welcher von oben auf den Messwiderstand 1 aufgebracht wird. Sowohl der Deckel 4 wie auch der weitere Deckel 11 werden jeweils mit gezeigten Klipsverbindern mit dem Messwiderstand 1 verklipst. Im zusammengebauten Zustand ergibt sich somit ein kompaktes und dichtes Gehäuse.

Es sei verstanden, dass die Pressfitpins 5 der zweiten Gruppe von Pressfitpins auch als Steckkontakte bezeichnet werden können. Die beiden Deckel 4, 11 liegen typischerweise auf jeweiligen ebenen Oberflächen des Messwiderstands 1 auf. Die Deckel 4, 11 können beispielsweise wannenförmig ausgeformt sein.

In dem gezeigten Ausführungsbeispiel der Fig. 1 ragt der Messwiderstand auf mehreren Seiten aus dem Gehäuse 7 heraus. Dies ist speziell für eine Vorrichtung zur Strommessung vorteilhaft, weil an dem aus dem Gehäuse 7 herausragenden Teil des Messwiderstands vorteilhaft Zuleitungen für den zu messenden Strom angeschlossen werden können. Auch andere elektrische Bauteile als ein Messwiderstand 1 können grundsätzlich verwendet und vorteilhaft mit der Leiterplatte 2 verbunden werden. Diese können sowohl aus dem Gehäuse 7 herausragen wie auch nicht aus dem Gehäuse 7 herausragen. Für den erfindungsgemäßen Deckel ist der erste Fügepartner ein Messwiderstand.

Bei der Ausführung von Fig. 6 sei insbesondere erwähnt, dass der Deckel 4 mit integriertem Stecker 6 eine Trägerstruktur 8 mit Pressfitpins 3 der ersten Gruppe von Pressfitpins aufweist, welche in einem ersten Arbeitsgang mit einer dickeren Einpresszone bzw. den ersten Pressfitzonen 3a in die vier dafür vorgesehenen ersten Pressfit-Löcher 9 des Messwiderstands 1 eingepresst werden können. Anschließend kann die Leiterplatte 2 mit den dafür vorgesehenen Pressfit-Löchern 10 in die dünneren Einpress-Zonen bzw. zweiten Pressfitzonen 3b am Ende der jeweiligen Pressfitpins 3 eingepresst werden. Zugleich können die Pressfitpins 5 der zweiten Gruppe von Pressfitpins, welche mit elektrischen Leitern des Steckers 6 verbunden sind, in die Leiterplatte 2 eingepresst werden. Schließlich wird die Anordnung mit dem weiteren Deckel 11 verschlossen.

Es ist in Figur 6 gut zu erkennen, dass die Pressfitpins 3 der ersten Gruppe in zwei Paaren hintereinander angeordnet sind, wobei die Pressfitpins jedes Paars elektrisch über die Trägerstruktur 8 miteinander verbunden sind. Eine Stromrichtung verläuft in der gezeigten Ausführung quer zu jeweiligen Verbindungslinien zwischen Pressfitpins 3 eines jeweiligen Paars. Damit werden die weiter oben erwähnten Vorteile erreicht.

Es sei verstanden, dass anstelle von Pressfitpins mit zwei Pressfitzonen oder einer Pressfitzone auch mehr als zwei Pressfitzonen beispielsweise mit ansteigender Dicke kaskadiert werden können, so dass Mehrfach-Pressfitpins bzw. Mehrfach-Einpress-Pins für drei oder mehr Fügepartner entstehen. Erwähnte Schritte des erfindungsgemäßen Verfahrens können in der angegebenen Reihenfolge ausgeführt werden. Sie können jedoch auch in einer anderen Reihenfolge ausgeführt werden. Das erfindungsgemäße Verfahren kann in einer seiner Ausführungen, beispielsweise mit einer bestimmten Zusammenstellung von Schritten, in der Weise ausgeführt werden dass keine weiteren Schritte ausgeführt werden. Es können jedoch grundsätzlich auch weitere Schritte ausgeführt werden, auch solche welche nicht erwähnt sind.

## Patentansprüche

1. Deckel (4) für ein Gehäuse (7), welcher folgendes aufweist:
- eine Trägerstruktur (8), und
- eine Anzahl von Pressfitpins (3, 5), welche von der Trägerstruktur (8) abstehen,
- wobei die Trägerstruktur (8) von einem Deckelmaterial ummantelt ist, und
- wobei jeder Pressfitpin (3) einer ersten Gruppe von Pressfitpins jeweils eine erste Pressfitzone (3a) und eine zweite Pressfitzone (3b) aufweist, wobei die erste Pressfitzone (3a) näher an der Trägerstruktur (8) angeordnet ist als die zweite Pressfitzone (3b), und wobei die erste Pressfitzone (3a) eine größere maximale Querschnittsfläche aufweist als die zweite Pressfitzone (3b), wobei
- der Deckel (4) mit einem ersten Fügepartner (1) und einem zweiten Fügepartner (2) verbunden ist,
- wobei die ersten Pressfitzonen (3a) in den ersten Fügepartner (1a) eingepresst sind und die zweiten Pressfitzonen (3b) in den zweiten Fügepartner (2) eingepresst sind,
wobei
- der erste Fügepartner (1) ein Messwiderstand (1) ist; und
- der zweite Fügepartner (2) eine Leiterplatte (2) ist.

2. Deckel (4) nach Anspruch 1, **dadurch gekennzeichnet, dass**
- die Pressfitpins (3) der ersten Gruppe von Pressfitpins materialschlüssig mit der Trägerstruktur (8) ausgebildet sind.

3. Deckel (4) nach einem der vorhergehenden Ansprüche, **dadurch gekennzeichnet, dass**
- jeder Pressfitpin (5) einer zweiten Gruppe von Pressfitpins eine Querschnittsfläche aufweist, welche durchgehend kleiner ist als die maximale Querschnittsfläche der ersten Pressfitzone (3a).

4. Deckel (4) nach einem der vorhergehenden Ansprüche, **dadurch gekennzeichnet, dass**
- die erste Pressfitzone (3a) und die zweite Pressfitzone (3b) jeweils beabstandet voneinander sind;
oder
- die erste Pressfitzone (3a) an die jeweilige zweite Pressfitzone (3b) unmittelbar angrenzt.

5. Deckel (4) nach einem der vorhergehenden Ansprüche, **dadurch gekennzeichnet, dass**
- die erste Gruppe vier Pressfitpins (3) umfasst, welche in einem ersten Paar und einem zweiten Paar hintereinander angeordnet sind.

6. Deckel (4) nach einem der vorhergehenden Ansprüche, **dadurch gekennzeichnet, dass**
- der Deckel (4) ferner einen integrierten Stecker (6) aufweist.

7. Deckel (4) nach Anspruch 6 sowie nach Anspruch 3, **dadurch gekennzeichnet, dass**
- die Pressfitpins (5) der zweiten Gruppe mit elektrischen Leitern des Steckers (6) verbunden sind.

8. Deckel (4) nach einem der vorhergehenden Ansprüche, **dadurch gekennzeichnet, dass**
- die Trägerstruktur (8) eine Anzahl von Pressfitpins (3, 5) mit anderen Pins und/oder anderen elektrischen Leitern verbindet.

9. Gehäuse (7) mit einem Deckel (4) nach einem der vorhergehenden Ansprüche, wobei das Gehäuse (7) einen Innenraum umschließt.

10. Batteriesensor, aufweisend
- einen Messwiderstand (1), und
- eine Messschaltung, welche dazu konfiguriert ist, eine über zumindest einem Teil des Messwiderstands (1) abfallende Spannung zu messen,
wobei
- der Messwiderstand (1) als Teil eines die Messschaltung umschließenden Gehäuses (7) ausgebildet ist,
- wobei der Batteriesensor einen unteren und/oder einen oberen Deckel (4, 11) aufweist, wobei der Messwiderstand und der oder die Deckel (4, 11) zusammen das Gehäuse (7) bilden, und
- wobei zumindest einer der Deckel (4) gemäß einem der Ansprüche 1 bis 9 ausgebildet ist, die ersten Pressfitzonen (3a) in den Messwiderstand (1) eingepresst sind und die Messschaltung auf einer Leiterplatte (2) aufgebracht ist, in welche die zweiten Pressfitzonen (3b) eingepresst sind.

11. Batteriesensor nach Anspruch 10, wobei zumindest einer der Deckel (4) ferner die Merkmale des Anspruchs 7 aufweist und Pressfitzonen (5a) der Pressfitpins (5) der zweiten Gruppe in die Leiterplatte (2) eingepresst sind.

12. Batteriesensor nach einem der Ansprüche 10 oder 11, wobei zumindest einer der Deckel (4) ferner die Merkmale des Anspruchs 5 aufweist, das erste Paar in einer Stromrichtung des Batteriesensors gesehen vor dem zweiten Paar angeordnet ist, eine Verbindungslinie zwischen den Pressfitpins (3) des ersten Paars quer zur Stromrichtung ausgerichtet ist und eine Verbindungslinie zwischen den Pressfitpins (3) des zweiten Paars quer zur Stromrichtung ausgerichtet ist.

13. Verfahren zum Herstellen eines Batteriesensors, insbesondere eines Batteriesensors nach einem der Ansprüche 10 bis 12, welches folgende Schritte aufweist:
- Bereitstellen eines Deckels (4) nach einem der Ansprüche 1 bis 9,
- Einpressen der ersten Pressfitzonen (3a) in einen Messwiderstand (1), und
- Einpressen der zweiten Pressfitzonen (3b) in eine Leiterplatte (2).

## Claims

1. Cover (4) for a housing (7), which cover has the following:
- a carrier structure (8), and
- a number of press-fit pins (3, 5) which protrude from the carrier structure (8),
- wherein the carrier structure (8) is sheathed by a cover material, and
- wherein each press-fit pin (3) of a first group of press-fit pins in each case has a first press-fit zone (3a) and a second press-fit zone (3b), wherein the first press-fit zone (3a) is arranged closer to the carrier structure (8) than the second press-fit zone (3b), and wherein the first press-fit zone (3a) has a larger maximum cross-sectional area than the second press-fit zone (3b), wherein
- the cover (4) is connected to a first joining partner (1) and a second joining partner (2),
- wherein the first press-fit zones (3a) are pressed into the first joining partner (1a) and the second press-fit zones (3b) are pressed into the second joining partner (2),
wherein
- the first joining partner (1) is a measurement resistor (1);and
- the second joining partner (2) is a printed circuit board (2).

2. Cover (4) according to Claim 1, **characterized in that**
- the press-fit pins (3) of the first group of press-fit pins are formed in a materially cohesive manner with the carrier structure (8).

3. Cover (4) according to either of the preceding claims, **characterized in that**
- each press-fit pin (5) of a second group of press-fit pins has a cross-sectional area which is consistently smaller than the maximum cross-sectional area of the first press-fit zone (3a).

4. Cover (4) according to one of the preceding claims, **characterized in that**
- the first press-fit zone (3a) and the second press-fit zone (3b) are respectively at a distance from one another; or
- the first press-fit zone (3a) directly adjoins the respective second press-fit zone (3b).

5. Cover (4) according to one of the preceding claims, **characterized in that**
- the first group comprises four press-fit pins (3) which are arranged in a first pair and a second pair one behind the other.

6. Cover (4) according to one of the preceding claims, **characterized in that**
- the cover (4) further has an integrated plug (6).

7. Cover (4) according to Claim 6 and also according to Claim 3, **characterized in that**
- the press-fit pins (5) of the second group are connected to electrical conductors of the plug (6).

8. Cover (4) according to one of the preceding claims, **characterized in that**
- the carrier structure (8) connects a number of press-fit pins (3, 5) to other pins and/or other electrical conductors.

9. Housing (7) having a cover (4) according to one of the preceding claims, wherein the housing (7) encloses an interior space.

10. Battery sensor, having
- a measurement resistor (1), and
- a measurement circuit which is configured to measure a voltage which is dropped across at least a portion of the measurement resistor (1),
wherein
- the measurement resistor (1) is in the form of part of a housing (7) which encloses the measurement circuit,
- wherein the battery sensor has a lower and/or an upper cover (4, 11), wherein the measurement resistor and the cover or the covers (4, 11) together form the housing (7), and
- wherein at least one of the covers (4) is designed according to one of Claims 1 to 9, the first press-fit zones (3a) are pressed into the measurement resistor (1), and the measurement circuit is mounted on a printed circuit board (2) into which the second press-fit zones (3b) are pressed.

11. Battery sensor according to Claim 10, wherein at least one of the covers (4) further has the features of Claim 7 and press-fit zones (5a) of the press-fit pins (5) of the second group are pressed into the printed circuit board (2).

12. Battery sensor according to either of Claims 10 and 11, wherein at least one of the covers (4) further has the features of Claim 5, the first pair is arranged in front of the second pair as seen in a direction of current of the battery sensor, a connecting line between the press-fit pins (3) of the first pair is oriented transversely in relation to the direction of current, and a connecting line between the press-fit pins (3) of the second pair is oriented transversely in relation to the direction of current.

13. Method for producing a battery sensor, in particular a battery sensor according to one of Claims 10 to 12, which method has the following steps:
- providing a cover (4) according to one of Claims 1 to 9,
- pressing the first press-fit zones (3a) into a measurement resistor (1), and
- pressing the second press-fit zones (3b) into a printed circuit board (2).

## Revendications

1. Couvercle (4) pour un boîtier (7), présentant les éléments suivants :
- une structure de support (8), et
- un nombre de broches insérées à force (3, 5) qui dépassent de la structure de support (8),
- la structure de support (8) étant enrobée d'un matériau de recouvrement, et
- dans lequel chaque broche insérée à force (3) d'un premier groupe de broches insérées à force présente une première zone d'insertion à force (3a) et une deuxième zone d'insertion à force (3b) respectivement, la première zone d'insertion à force (3a) étant disposée plus près de la structure de support (8) que la deuxième zone d'insertion à force (3b), et la première zone d'insertion à force (3a) présentant une superficie de la section maximale supérieure à la deuxième zone d'insertion à force (3b),
- dans lequel le couvercle (4) est relié à une première pièce d'accouplement (1) et à une deuxième pièce d'accouplement (2),
- dans lequel les premières zones d'insertion à force (3a) sont enfoncées dans la première pièce d'accouplement (1a) et les deuxièmes zones d'insertion à force (3b) sont enfoncées dans la deuxième pièce d'accouplement (2),
- dans lequel la première pièce d'accouplement (1) est une résistance de mesure (1) ; et
- dans lequel la deuxième pièce d'accouplement (2) est une carte de circuits imprimés (2).

2. Couvercle (4) selon la revendication 1, **caractérisé en ce que**
- les broches insérées à force (3) du premier groupe de broches insérées à force sont réalisées par liaison de matière avec la structure de support (8).

3. Couvercle (4) selon l'une quelconque des revendications précédentes, **caractérisé en ce que**
- chaque broche d'insertion à force (5) d'un deuxième groupe de broches insérées à force présente une superficie de la section qui est toujours inférieure à la superficie de la section maximale de la première zone d'insertion à force (3a).

4. Couvercle (4) selon l'une quelconque des revendications précédentes, **caractérisé en ce que**
- la première zone d'insertion à force (3a) et la deuxième zone d'insertion à force (3b) sont espacées l'une de l'autre, respectivement ; ou
- la première zone d'insertion à force (3a) est directement adjacente à la deuxième zone d'insertion à force (3b), respectivement.

5. Couvercle (4) selon l'une quelconque des revendications précédentes, **caractérisé en ce que**
- le premier groupe comprend quatre broches insérées à force (3) qui sont disposées les unes après les autres dans une première paire et une deuxième paire.

6. Couvercle (4) selon l'une quelconque des revendications précédentes, **caractérisé en ce que**
- le couvercle (4) présente en outre un connecteur intégré (6).

7. Couvercle (4) selon la revendication 6 ainsi que la revendication 3, **caractérisé en ce que**
- les broches insérées à force (5) du deuxième groupe sont reliées à des conducteurs électriques du connecteur (6).

8. Couvercle (4) selon l'une quelconque des revendications précédentes, **caractérisé en ce que**
- la structure de support (8) relie un nombre de broches insérées à force (3, 5) à d'autres broches et/ou à d'autres conducteurs électriques.

9. Boîtier (7) doté d'un couvercle (4) selon l'une quelconque des revendications précédentes, dans lequel le boîtier (7) entoure un espace intérieur.

10. Capteur de batterie, présentant
- une résistance de mesure (1), et
- un circuit de mesure qui est configuré pour mesurer une tension retombant sur au moins une partie de la résistance de mesure (1),
- dans lequel la résistance de mesure (1) est réalisée comme une partie du boîtier (7) entourant le circuit de mesure,
- dans lequel le capteur de batterie présente un couvercle inférieur et/ou supérieur (4, 11), la résistance de mesure et/ou le couvercle (4, 11) formant ensemble le boîtier (7), et
- dans lequel au moins l'un des couvercles (4) étant réalisé selon l'une quelconque des revendications 1 à 9, les premières zones d'insertion à force (3a) sont enfoncées dans la résistance de mesure (1) et le circuit de mesure est appliqué à une carte de circuits imprimés (2) dans laquelle sont enfoncées les deuxièmes zones d'insertion à force (3b).

11. Capteur de batterie selon la revendication 10, dans lequel au moins l'un des couvercles (4) présente en outre les particularités de la revendication 7 et les zones d'insertion à force (5a) des broches insérées à force (5) du deuxième groupe sont enfoncées dans la carte de circuits imprimés (2).

12. Capteur de batterie selon l'une quelconque des revendications 10 ou 11, dans lequel au moins l'un des couvercles (4) présente en outre les particularités de la revendication 5, la première paire, vue dans une direction de courant du capteur de batterie, est disposée avant la deuxième paire, une ligne de jonction entre les broches insérées à force (3) de la première paire est orientée transversalement à la direction de courant et une ligne de jonction entre les broches insérées à force (3) de la deuxième paire est orientée transversalement à la direction de courant.

13. Procédé de fabrication d'un capteur de batterie, en particulier d'un capteur de batterie selon l'une quelconque des revendications 10 à 12, présentant les étapes suivantes consistant à :
- prévoir un couvercle (4) selon l'une quelconque des revendications 1 à 9,
- enfoncer la première zone d'insertion à force (3a) dans une résistance de mesure (1), et
- enfoncer la deuxième zone d'insertion à force (3b) dans une carte de circuits imprimés (2).
